(19) Europäisches Patentamt
European Patent Office
Office européen des brevets

(11) EP 0 921 402 A2

(12) EUROPEAN PATENT APPLICATION

(43) Date of publication:
09.06.1999 Bulletin 1999/23

(51) Int Cl.⁶: G01R 13/34

(21) Application number: 98309260.2

(22) Date of filing: 12.11.1998

(84) Designated Contracting States:
AT BE CH CY DE DK ES FI FR GB GR IE IT LI LU
MC NL PT SE
Designated Extension States:
AL LT LV MK RO SI

(30) Priority: 19.11.1997 JP 31869897

(71) Applicants:
• ANDO ELECTRIC CO., LTD.
Tokyo 144 (JP)
• NIPPON TELEGRAPH AND
TELEPHONE CORPORATION
Tokyo 160 (JP)

(72) Inventors:
• Takeuchi, Noruaki,c/o Ando Electric Co.Ltd.
Ota-ku, Tokyo (JP)

• Yanagisawa, Yoshiki,c/o Ando Electric Co., Ltd.
Ota-ku, Tokyo (JP)
• Kikuchi, Jun,c/o Ando Electric Co.,Ltd.
Ota-ku, Tokyo (JP)
• Endou, Yoshio,c/o Ando Electric Co.,Ltd.
Ota-ku, Tokyo (JP)
• Siinagawa, Mitsuru,c/o Nippon Telegr. and
Tel.Corp
Shinjuku-ku, Tokyo (JP)
• Nagatsuma, Tadao,c/o Nippon Telegr. and Tel.
Corp.
Shinjuku-ku, Tokyo (JP)
• Yamada, Junzo,c/o Nippon Telegr. and Tel.Corp.
Shinjuku-ku, Tokyo (JP)

(74) Representative: Read, Matthew Charles et al
Venner Shipley & Co.
20 Little Britain
London EC1A 7DH (GB)

(54) Electro-optic sampling oscilloscope

(57) The present invention relates to an optic-electro sampling oscilloscope. A timing generation circuit (4a) in an electro-optic sampling oscilloscope comprises: a fast ramp generation circuit (11) for outputting a fast ramp waveform based on a signal from a trigger circuit (3); a slow ramp generation circuit (12) for gradually raising the signal level based on a signal from a counter (14) up to a predetermined step number; a comparator (13) for outputting signals based on the comparison results of the output signals of the fast ramp generation circuit (11) and the slow ramp generation circuit (12); and a counter (14) for counting output signals from the comparator (13) up to a predetermined number. In addition, the timing generation circuit (4a) uses the output signals from the comparator (13) for the timing for optical pulse output by the optical pulse generation circuit (5) and uses the output signals from the counter (14) for the conversion timing for the A/D conversion by the A/D converter (6).

## Description

## BACKGROUND OF THE INVENTION

### Field of the Invention

The present invention relates to an electro-optic sampling oscilloscope for observing the waveform of signal to be measured using timing signals from a timing generation circuit which, based on sampling rates, generates timing for the optical pulse output used in electro-optic probes and conversion timing for A/D converter which carry out A/D conversion of signals from the electro-optic probe. In particular, the present invention relates to an electro-optic sampling oscilloscope characterized by comprising a timing generation circuit.

This application is based on patent application No.Hei 9-318698 filed in Japan, the content of which is incorporated herein by reference.

### Description of the Related Art

It is possible to observe the waveform of a signal to be measured by coupling the electric field generated by the signals to be measured to an electro-optic crystal, causing laser light to enter this electro-optic crystal, and using the polarization state of the laser light. Here, it is possible to use this laser light in pulse form, and to conduct measurement with extremely high time resolution when the sampling of the signal to be measured is conducted. An electro-optic sampling oscilloscope employs an electro-optic probe which takes advantage of this phenomenon.

In comparison with conventional sampling oscilloscopes which employ electrical probes, such an electro-optic sampling oscilloscope (herein below termed an "EOS" oscilloscope) has the following characteristic features (Shinagawa, et al: "A High-Impedance Probe Based on Electo-Optic Sampling," Proceeding of the 15th Meeting on Lightwave Sensing Technology, May 1995, pp 123-129):

(1) When signals are measured, a ground wire is not required, so that measurement is simplified.
(2) The metal pin, which is at the lead end of the electro-optic probe, is isolated from the circuit system, so that it is possible to realize high input impedance, and as a result, the state at the point at which measurement is conducted is essentially free of fluctuations.
(3) Since optical pulses are employed, measurement is possible in a broad band up to the order of GHz.

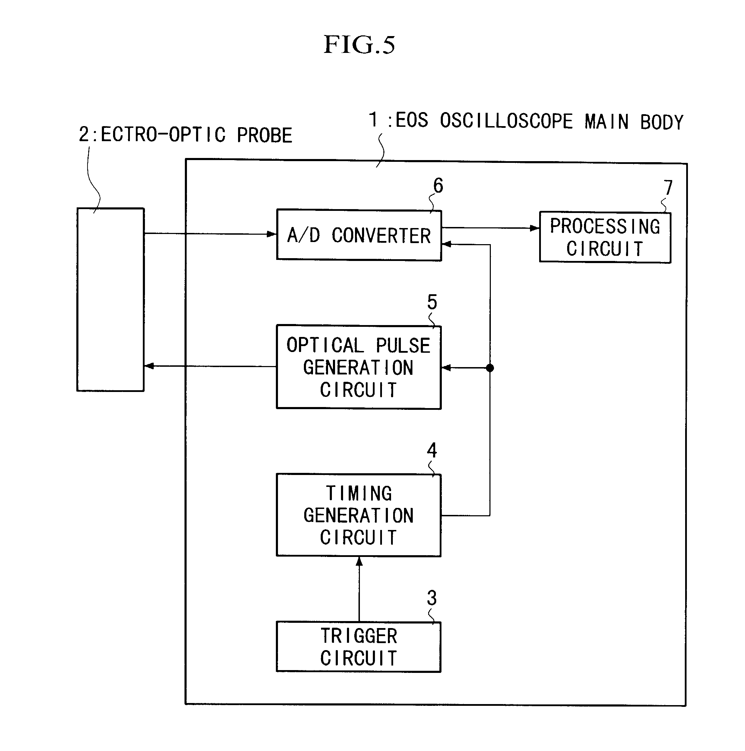

Figure 5 is a diagram showing the structure of an EOS oscilloscope.

The EOS oscilloscope comprises an EOS oscilloscope main body 1 and the electro-optic probe 2.

The periodic signals, which are supplied to the signals to be measured, are also input into the trigger circuit 3 for the purpose of synchronism with the signals to be measured. Then, the trigger circuit 3 makes this signal into a signal which corresponds to the sampling rate which is the sampling period of the signal to be measured and supplies it to the timing generation circuit 4. Based on the signal from the trigger circuit 3, the timing generation circuit 4 generates timing for the output of optical pulses by the optical pulse generation circuit, and generates conversion timing for A/D conversion of the signal from the electro-optic probe 2 by the A/D converter 6. In addition, the optical pulse generation circuit 5 generates optical pulses using the signals from the timing generation circuit 4, and supplies these optical pulses to the electro-optic probe 2. Next, the optical pulses which have undergone polarization change in the electro-optic probe 2 are detected the polarization change and the like by the polarization detection optical system (not shown in the Figure) in the electro-optic probe 2, and this signal is inputted to the EOS oscilloscope main body 1. Next, A/D converter 6 carries out the amplification and A/D conversion of the input signal using the timing from the timing generation circuit 4. The processing circuit 7 carries out the processing for the purpose of displaying the signal that is the subject of the measurement.

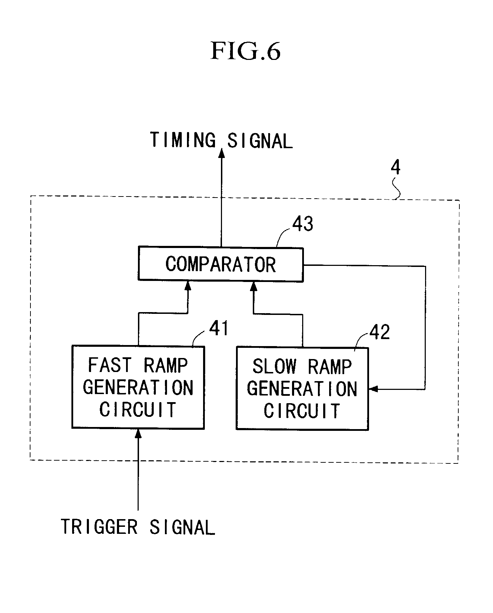

Figure 6 is a diagram showing a conventional example of the structure of a timing generation circuit 4 of an EOS oscilloscope shown in Figure 5. As shown in Figure 6, the timing generation circuit 4 comprises a fast ramp generation circuit 41 which outputs fast ramp waveforms using signals from the trigger circuit 3 as an input signals; a slow ramp generation circuit 42 which gradually raises the signal level based on the signal from the comparator 43 up to a predetermined step number; and a comparator 43 which outputs a signal based on the comparison results of the output signal of the fast ramp generation circuit 41 and the slow ramp generation circuit 43. Moreover, the output signals from the comparator 43 are supplied to the slow ramp generation circuit 42 as well as being used as the timing for the purpose of outputting optical pulses from the optical pulse generation circuit 5 and as the conversion timing for the A/D converter 6.

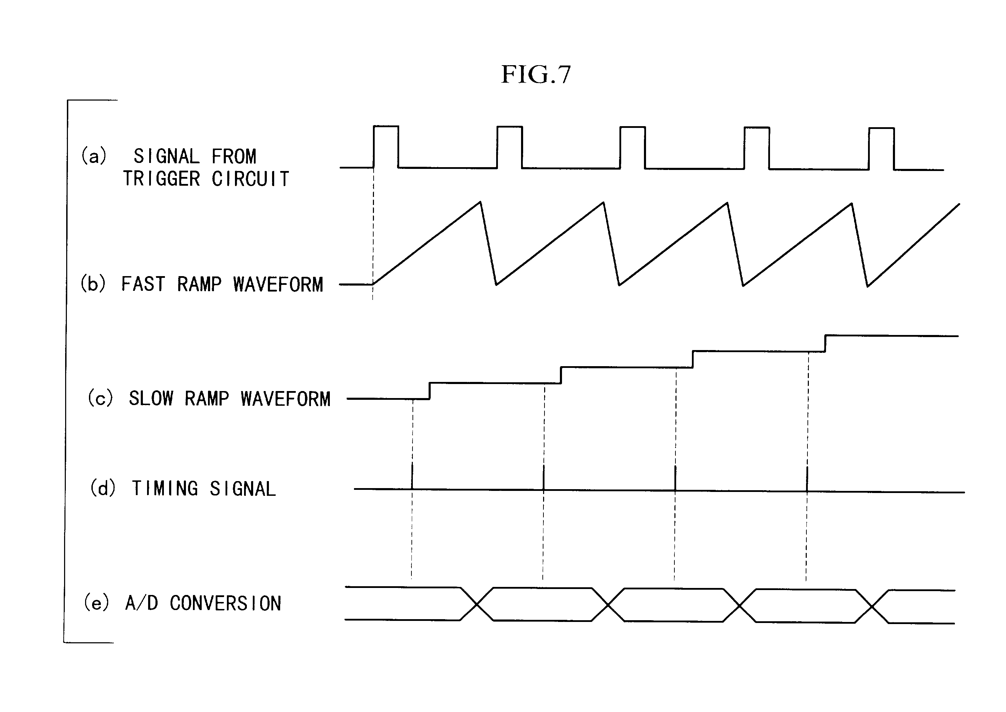

Next, the operation of this timing generation circuit 4 will be explained using the timing chart shown in Figure 7.

As shown in part (a) in Figure 7, when a signal corresponding to the sampling rate from the trigger circuit 3 is input, the fast ramp generation circuit 41 outputs a fast ramp waveform like that shown in part (b) in Figure 7. Here, the "fast ramp waveform" refers to a repeating waveform in which the signal level begins to increase from the initial value at the input timing of the signal from the trigger circuit 3, and the signal level returns to the initial value at a predetermined timing. In addition, as shown in part (c) in Figure 7, the slow ramp generation circuit 42 outputs a slow ramp waveform the signal level of which gradually increases based on the signal from the comparator 43. Moreover, this slow ramp waveform returns to the initial signal level when a predetermined step number is reached. The comparator 43 carries out a comparison of the signals from the fast ramp generation circuit 41 and the slow ramp generation circuit 42 and outputs a timing signal like that shown in part (d) in Figure 7.

Moreover, the A/D converter 6 of Figure 5 carries out A/D conversion of the signal from the electro-optic probe 2 at the timing shown in part (e) in Figure 7 based on the signal from the timing generation circuit 4. Thereby, the A/D converter 6 A/D converts the signal obtained for each optical pulse from the electro-optic probe 2.

In addition, when the power (quantity of light) of the optical pulse from the optical pulse generation circuit 5 is not sufficient, the S/N ratio of the signal which measures the signal to be measured deteriorates. In order to solve this, increasing the average power of the optical pulse would be suitable.

In addition, if
the sampling rate of the signal to be measured is: $fs$
the clock frequency of the A/D conversion due to the A/D converter 6 is: $fad$
display data number (number of data stored from the sampling) is: $n$
the waveform number of the data number $n$ is: $m$
the step number of the slow ramp generation circuit 42 is: $k$
the input clock of the slow ramp generation circuit 42 is: $fda$

then, in the timing generation circuit 4 of Figure 6,
$fad = fda$.

In addition, since the slow ramp generation circuit 42 is increased by one step signal level for each sampling pulse,
$k = n$.
[0007]
Here, the time taken in 1 step is
$k/fda$ and, since the waveform of the $m$ period during this interval is measured, the beat frequency $\Delta f$ is

$$\Delta f = m \times fda/k \qquad (1).$$

For example, when $k = 1000$, $fda = 1$ MHz, and $m = 2$, from formula (1), beat frequency $\Delta f$ is 2[kHz]. In this situation, if there is detection to 50th order higher harmonic, a band of 100 (=2 × 50) [kHz] is necessary.

Next, the situation in which the sampling rate has been increased is considered. In the EOS oscilloscope mentioned above, since
$fs = fad = fda$,
[0015] if the sampling rate is increased, according to Formula (1) the beat frequency will rise. Here, if detection to the 50th order higher harmonic is made a condition, the detection band widens in accordance with the sampling rate. when the detection band widens, various system noises enter the band, for example, even when the quantity of the light of the optical pulses is increased to improve the S/N ratio, it is not really possible to anticipate improvements in the S/N ratio. In addition, if the detection band is not widened in order that noise is not increased, this is connected with worsening of the frequency characteristics.

## SUMMARY OF THE INVENTION

The present invention was made in view of these circumstances and the object of the present invention is providing an EOS oscilloscope which is designed to improve the S/N ratio of EOS sampling oscilloscopes while preventing deterioration in the frequency characteristics when the sampling rate is increased.

In order to achieve the above-mentioned objective, the present invention provides an electro-optic sampling oscilloscope for observing the waveform of a signal to be measured using a timing signal from a timing generation circuit which generates timing for the optical pulse output used in an electro-optic probe, and conversion timing for an A/D converter which carries out A/D conversion of signals from said electro-optic probe, based on a sampling rate, wherein: said timing generation circuit comprises a slow ramp generation circuit which is used for generating said timing for the optical pulse output and said conversion timing, and said timing generation circuit generates a signal for said conversion timing having the cycle longer than the cycle of said timing for the optical pulse output while operating said slow ramp generation circuit at the cycle of said conversion timing.

Also the present invention provides an electro-optic sampling oscilloscope for observing a waveform of a signal to be measured using a signal from a timing generation circuit which generates timing for optical pulse output used in an electro-optic probe and conversion timing for an A/D converter which carries out A/D conversion of signals from said electro-optic probe based on a sampling rate, and using a processing circuit which processes the output signal from said A/D converter, wherein: said timing generation circuit comprises a slow ramp generation circuit which is used for generating said timing for the optical pulse output and said conversion timing, and said timing generation circuit operates said slow ramp generation circuit at a cycle slower than the cycle of said timing for the optical pulse output and said conversion timing, and said processing circuit comprises an integration circuit which digitally integrates the output data from said A/D converter at the operating cycle of said slow ramp generation circuit.

Thereby, the quantity of light for obtaining single sampling data increases proportionally with the operation cycle of the slow ramp generation circuit, and the S/N ratio of the signal to be measured is improved.

The reference symbols used in the claims are not influenced to the interpretation of the claims.

**BRIEF DESCRIPTION OF THE DRAWINGS**

Figure 1 is a diagram showing the structure of an EOS oscilloscope according to an embodiment of the present invention.

Figure 2 is a timing chart for the purpose of explaining the operation of the timing generation circuit 4a of Figure 1.

Figure 3 is a diagram showing the structure of an EOS oscilloscope according to another embodiment of the present invention.

Figure 4 is a timing chart for the purpose of explaining the operation of the timing generation circuit 4b of Figure 3.

Figure 5 is a diagram showing the structure of an example of a conventional EOS oscilloscope.

Figure 6 is a diagram showing the structure of an example of a conventional timing generation circuit 4.

Figure 7 is a timing chart for the purpose of explaining the operation of the timing generation circuit 4 of Figure 6.

**DESCRIPTION OF PREFERRED EMBODIMENTS**

The following embodiments does not restrict the interpretation of the claims relating to the present invention, and the combination of all the features explained in the embodiments is always not being indispensable means of solving the problem.

In the following, an electro-optic sampling oscilloscope according to embodiments of the present invention will be explained with reference to Figures.

(First Embodiment)

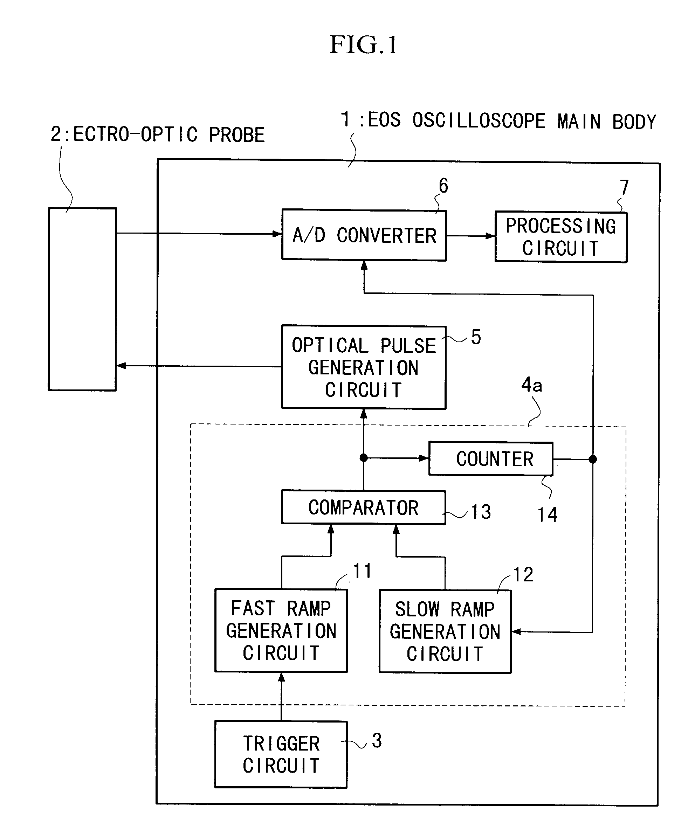

Figure 1 is a diagram showing the structure of an electro-optic sampling oscilloscope according to a first embodiment of the present invention. From Figure 1, the EOS oscilloscope comprises an EOS oscilloscope main body 1 and an electro-optic probe 2. In addition, the EOS oscilloscope main body 1 comprises a trigger circuit 3, a timing generation circuit 4a, an optical pulse generation circuit 5, and A/D converter 6, and a processing circuit 7.

Here, in order to be synchronous with the signal to be measured, a periodic signal for supply to the signal to be measured is also input into the trigger circuit 3 as a trigger signal. This trigger circuit 3 makes this inputted signal into a signal which corresponds to a sampling rate which is the sampling cycle of the signal to be measured and supplies it to timing generation circuit 4a.

In addition, when called an "EOS oscilloscope", there are situations in which this comprises the EOS oscilloscope main body 1 and the electro-optic probe 2 of Figure 1, and situations in which there is only the EOS oscilloscope main body 1.

The timing generation circuit 4a generates timing for the output of optical pulses from the optical pulse generation circuit 5 based on the signal from this trigger circuit 3, and is also generates conversion timing for A/D conversion of the signal from the electro-optic probe 2 by the A/D converter 6. Then, optical pulse generation circuit 5 generates optical pulses using the signal from timing generation circuit 4a, and supplies these optical pulses to the electro-optic probe 2.

In electro-optic probe 2, a polarization detection optical system (not shown in the Figure) detects the polarization change from optical pulses which have undergone polarization change, and these detection signals are input into the EOS oscilloscope main body 1. Next, the amplitude of these signals and A/D conversion of amplified signals using the timing from the timing generation circuit 4a are carried out by the A/D converter 6. The processing circuit 7 carries out the processing for the purpose of display, and the like, of the signal that is the subject of the measurement.

In addition, the timing generation circuit 4a comprises a fast ramp generation circuit 11, a slow ramp generation circuit 12, a comparator 13, and a counter 14. The fast ramp generation circuit 11 outputs a fast ramp waveform using the signal from the trigger circuit 3 as an input signal. The slow ramp generation circuit 12 outputs a slow ramp waveform in which the signal level is gradually increased based on the signal from the counter 14 up to a predetermined step number. The comparator 13 compares the output signals of the fast ramp generation circuit 11 and the slow ramp generation circuit 12, and outputs a signal based on the comparison results. The counter 14 counts the signals from the comparator 13 up to a predetermined number and outputs a signal at each count of the predetermined number. Moreover, the output from this comparator 13 is used as the timing for the output of the optical pulse by the optical pulse generation circuit 5. In addition, the output signal from the counter 14 is supplied to the A/D converter 6 as the conversion timing of the A/D converter 6 and is also supplied to the slow ramp generation circuit 12 for rising the signal level.

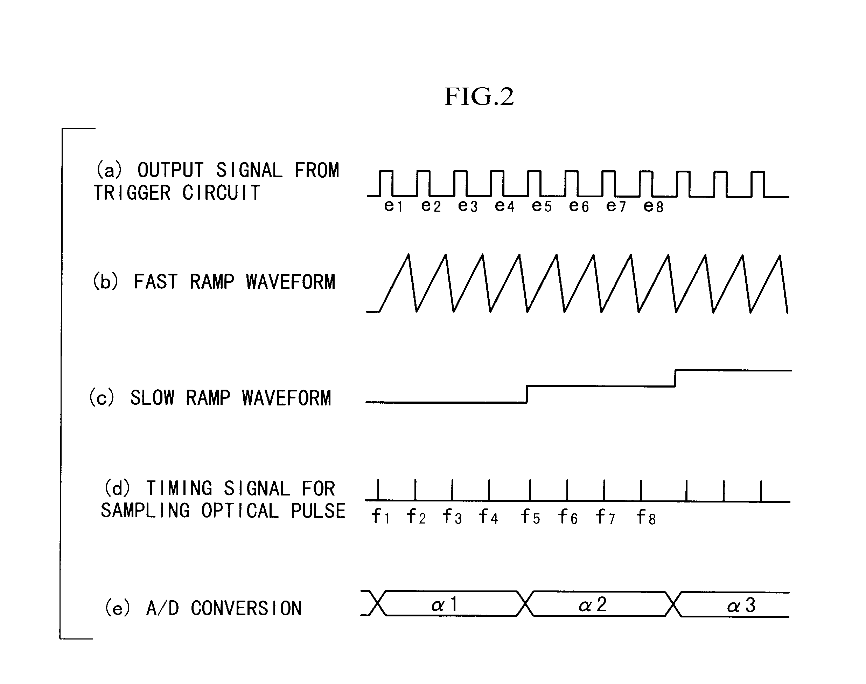

Next, the operation of this timing generation circuit 4a will be explained using the timing chart shown in Figure 2. Moreover, in the Example in Figure 2, the count number according to counter 14 is "4".

As shown in part (a) in Figure 2, when the signal corresponding to the sampling rate from the trigger circuit 3 is input into timing generation circuit 4a, the fast ramp generation circuit 11 outputs a fast ramp waveform as shown in part (b) in Figure 2. Here, as described above, "fast ramp waveform" refers to a repeating waveform in which the signal level starts to increase from the initial value at the input timing of the signal from the trigger circuit 3 and the signal level returns to the initial value at the predetermined timing. Moreover, the cycle of the trigger signal, which is input into the trigger circuit 3, is the same as the sampling rate or is shorter. When the cycle of the trigger signal is shorter than the sampling rate, the trigger signal is frequency-divided, and a signal is output having a sampling rate which has a cycle close to a desired sampling rate which is determined by the structure of the hardware of the EOS oscilloscope.

As shown in part (c) in Figure 2, the slow ramp generation circuit 12 outputs a slow ramp waveform in which the signal level gradually increases based on the signal from the counter 14. In addition, when this slow ramp waveform reaches a predetermined step, it returns to the initial signal level, and this is repeated. Here, the width of the rise in the signal level in each step is determined in accordance with the maximum value of the output signal from the fast ramp generation circuit 11 and the above mentioned predetermined step number. In addition, the above mentioned predetermined step is the display number of the sampling result of the signal to be measured, in other words, it is a value which is determined in accordance with the sample number stored by the processing circuit 7. In the example of the slow ramp waveform of part (c) in Figure 2, because the count number of the counter 14 is "4", for every 4 counts of the signals which are shown in part (d) in Figure 2, the signal level rises.

The comparator 13 compares the signal from the fast ramp generation circuit 11 and the slow ramp generation circuit 12, and outputs a timing signal for sampling optical pulse generation by the optical pulse generation circuit 5 as shown in part (d) in Figure 2. As is clear from a comparison of Figures 2(a) and (d), the output signals from the comparator 13 are output in an identical number of signals as the signals from the trigger circuit 3 but, using the signal from the fast ramp generation circuit 11 and the slow ramp generation circuit 12, the signal from the trigger circuit 3 is output after being delaying for a predetermined time. In addition, this delay time varies depending on the signal level of the slow ramp waveform. Therefore, the output signals f1 - f4 from the comparator 13 shown in (d) in Figure 2 are within the same signal level as the slow ramp waveform, therefore, they are delayed by the same time with respect to the signals e1 - e4 from trigger circuit 3 shown in (a) in Figure 2. In the same way, the output signals f5 - f8 from the comparator 13 shown in part (d) in Figure 2 are within the same signal level as the slow ramp waveform, therefore, they are delayed by the same time with respect to the signals e5 - e8 from the trigger circuit 3 shown in part (a) in Figure 2 and this delay time is different to that of output signals f1 - f4.

The A/D converter 6 in Figure 1 carries out A/D conversion of the signal from electro-optic probe 2, shown in (e) in Figure 2, based on the signal from counter 14 within the timing generation circuit 4a. In other words, A/D converter 6 carries out an operation in which the integration value of an analogue signal sampled by four sampling optical pulses is AID converted. More specifically, in the range of $\alpha 1$, A/D converter 6 analogue-integrates the analogue signals of measurement result obtained using the optical pulses output by timing signals f1 ~ f4 which are obtained at the same level in the slow ramp waveform. In the same way, in the range $\alpha 2$, A/D converter 6 analogue-integrates the analogue signals of measurement result obtained using optical pulses output by timing signals f5 ~ f8 which are obtained at the same level in the slow ramp waveform.

In the above-mentioned way, with respect to the sampling rate of the signal to be measured, the operation of the slow ramp generation circuit 12 is delayed, thereby, it is possible in processing circuit 7 to obtain single sampling data for each count number according to counter 14. Therefore, the quantity of light for obtaining single sampling data is proportional to the count number according to counter 14 and increases, and the S/N ratio improves.

In addition, in the EOS oscilloscope of the present embodiment, since the operating frequency ofthe slow ramp generation circuit 12 is longer than the sampling rate, in other words, the frequency of the generation of the optical pulses, according to Formula (1), it is possible to control the height of the beat frequency. Therefore, it is possible to prevent deterioration of the frequency characteristics when the sampling rate is raised.

Moreover, in the timing generation circuit 4a of the present embodiment, the operation of the slow ramp generation circuit 12 can be delayed, therefore, it is also advantageous for jitter.

(Second Embodiment)

In the First Embodiment, in the A/D converter 6, an analogue signal from the electro-optic probe 2 is integrated, but in the present embodiment, an example is shown in which a signal digitalized by the A/D converter 6 is digitally integrated in the processing circuit 7.

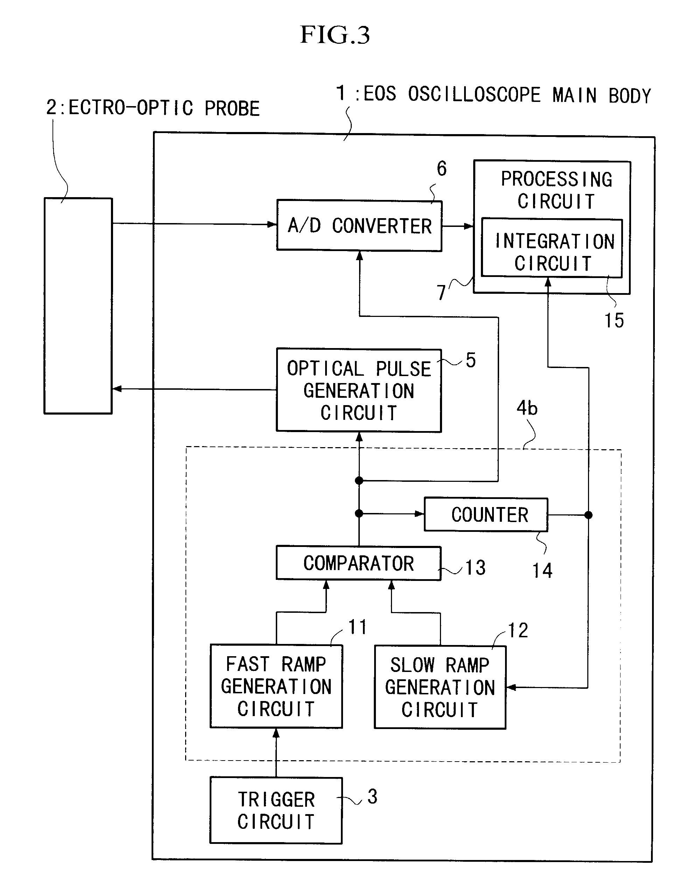

Figure 3 is a diagram showing the structure of the EOS oscilloscope according the another embodiment of the present invention, and reference 4b indicates a timing generation circuit. In addition, in this figure, parts which correspond to parts shown in Figure 1 are given the same references and their explanation is omitted.

Differences in the structure of Figure 3 with regard to that of Figure 1 are:

1) the output signal form the comparator 13 is used as the conversion timing by the A/D converter 6;
2) the processing circuit 7 comprises an integration circuit 15 for carrying out digital integration, and the output signal of counter 14 is used as the input signal for the purpose of obtaining integration timing.

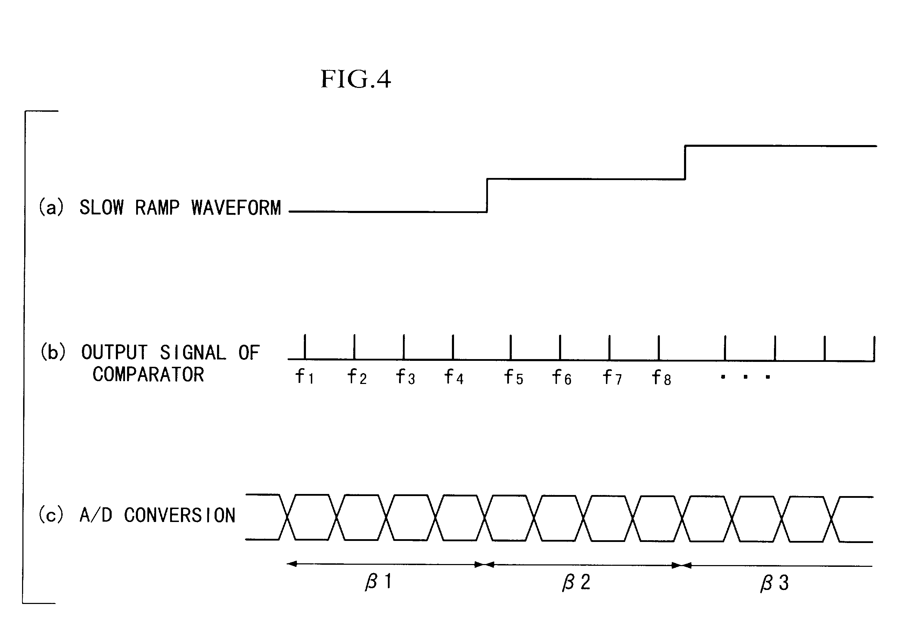

Next, the operation of this timing generation circuit 4b will be explained using the timing chart shown in Figure 4. In the example shown in Figure 4, the count number according to counter 14 is "4". In Figure 4, the signal from trigger circuit 3 and the signal from the fast ramp generation circuit 11 are the same as Figures 2(a) and (b) and these signals have been omitted.

Part (a) in Figure 4 shows the output signal from the slow ramp generation circuit 12, and part (b) in Figure 4 shows timing signals output by the comparator 13 for the optical pulse generation of the optical pulse generation circuit 13 and the conversion timing for the A/D converter 6. Moreover, these signals are also identical to part (c) and (d) in Figure 2.

Part (c) in Figure 4 shows A/D conversion timing by the A/D converter 6. The A/D converter shown in Figure 3 A/D converts the signal from the electro-optic probe 2 based on the signal from the comparator 13 in the timing generation circuit 4b. Thereby, the A/D converter 6 carries out the operation of A/D conversion for each analogue signal sampled by a sampling optical pulse.

On the other hand, the signal of the counter 14 shown in Figure 3 is sent to the integration circuit 15. In the example, since the count number according to the counter 14 is "4", the four digital data from the A/D converter 6 are added by integration circuit 15 and, thereby, integration in the digital circuit is carried out. In Figure 4, digitally integrated data is obtained for each reference β1, β2, β3 ... . Moreover, in the range of β1, the integration circuit 15 digitally integrates the digital data of measurement results obtained using optical pulses output by the timing signals f1 ~ f4 which are obtained at the same level in the slow ramp waveform. In the same way, in the range of β2, the integration circuit 15 digitally integrates the digital data of measurement results obtained using optical pulses output by the timing signals f5 ~ f8 which are obtained at the same level in the slow ramp waveform.

In the above-mentioned way, with respect to the sampling rate of the signal to be measured, the operation of the slow ramp generation circuit is delayed, thereby, it is possible in the processing circuit 7 to obtain single sampling data for each count number according to counter 14. Therefore, the quantity of light for obtaining single sampling data is proportional to the count number according to counter 14 and increases, and the S/N ratio improves.

In addition, in the EOS oscilloscope of the present embodiment, since the operating frequency of the slow ramp generation circuit 12 is longer than the sampling rate, in other words, the frequency of the generation of the optical pulses, according to Formula (1), it is possible to control the height of the beat frequency. Therefore, it is possible to prevent deterioration of the frequency characteristics when the sampling rate is raised.

Moreover, in the timing generation circuit 4b of the present embodiment, the operation of the slow ramp generation circuit 12 can be delayed, therefore, it is also advantageous for jitter.

As explained above, by means of the EOS oscilloscope of the present invention, it is possible to obtain the following effects.

In the timing generation circuit in the EOS oscilloscope, by delaying the operation of the slow ramp generation circuit, which is comprised by the timing generation circuit, with respect to the sampling rate of the signal to be measured:

1) it is possible to obtain single sampling data for each count number according to the counter which is a part of the timing generation circuit. Thereby, the quantity of light for obtaining single sampling data increases proportionally with the count number of the counter, and the S/N ratio is improved.

2) Since the operating frequency of the slow ramp generation circuit 12 is longer with respect to the sampling rate, in other words, the frequency of the generation of the optical pulses, according to Formula (1), it is possible to control the height of the beat frequency. Therefore, it is possible to prevent deterioration of the frequency characteristics when the sampling rate is raised.

3 ) In the timing generation circuit 4a of the present embodiment, the operation of the slow ramp generation circuit 12 can be delayed, therefore, it is also advantageous for jitter.

4) With the speed of the slow ramp maintained without change, it is possible to improve the sampling rate and the S/N ratio of the measured waveform is improved.

**Claims**

1. An electro-optic sampling oscilloscope for observing the waveform of a signal to be measured using a timing signal from a timing generation circuit (4a) which generates timing for the optical pulse output used in an electro-optic probe (2), and conversion timing for an A/D converter (6) which carries out A/D conversion of signals from said electro-optic probe (2) , based on a sampling rate, wherein:

said timing generation circuit (4a) comprises a slow ramp generation circuit (12) which is used for generating said timing for the optical pulse output and said conversion timing, and said timing generation circuit (4a) generates a signal for said conversion timing having the cycle longer than the cycle of said timing for the optical pulse output while operating said slow ramp generation circuit (12) at the cycle of said conversion timing.

2. An electro-optic sampling oscilloscope according to claim 1, wherein said timing generation circuit (4a) comprises:

a fast ramp generation circuit (11) which outputs a fast ramp waveform based on a signal related to the sampling rate; a slow ramp generation circuit (12) which gradually raises the signal level based on the input signal up to a predetermined step number; a comparator (13) which outputs a signal based on comparison results of the output signal of said fast ramp generation circuit (11) and said slow ramp generation circuit (12); and a counter (14) which counts the output signal from said comparator (13) up to a predetermined number, and wherein: said timing generation circuit (4a) outputs the signal from said comparator (13) as said timing for the optical pulse output and outputs the signal from said counter (14) as said conversion timing, and the signal from said counter (14) is supplied to said slow ramp generation circuit (12).

3. An electro-optic sampling oscilloscope for observing a waveform of a signal to be measured using a signal from a timing generation circuit (4b) which generates timing for optical pulse output used in an electro-optic probe(2) and conversion timing for an A/D converter (6) which carries out A/D conversion of signals from said electro-optic probe (2) based on a sampling rate, and using a processing circuit (7) which processes the output signal from said A/D converter (6), wherein:

said timing generation circuit (4b) comprises a slow ramp generation circuit (12) which is used for generating said timing for the optical pulse output and said conversion timing, and said timing generation circuit (4b) operates said slow ramp generation circuit at a cycle slower than the cycle of said timing for the optical pulse output and said conversion timing, and said processing circuit (7) comprises an integration circuit (15) which digitally integrates the output data from said A/D converter (6) at the operating cycle of said slow ramp generation circuit (12).

4. An electro-optic sampling oscilloscope according to claim 3, wherein said timing generation circuit (4b) comprises:

a fast ramp generation circuit (11) which outputs a fast ramp waveform based on a signal related to a sampling rate; a slow ramp generation circuit (12) which gradually increases the signal level based on the input signal up to a predetermined step number; a comparator (13) which outputs a signal based on comparison results of the output signal of said fast ramp generation circuit (11) and slow ramp generation circuit (12); and a counter (14) which counts the output signal from said comparator (13) up to a predetermined number, and wherein: the output signal from said comparator (13) is used as said timing for the optical pulse output and said conversion timing, and the output signal from said counter (14) is used as the input signal for said slow ramp generation circuit (12) and is supplied to said integration circuit (15).

5. Drive apparatus for an electro-optic probe, comprising a pulse generator (4a) for generating sequential pulses with a predetermined periodicity to drive the probe, and circuitry (6, 7) to process variable value signals produced by the probe in response to the pulses **characterised by** means to integrate successively the value of the signals over a period greater than the periodicity of the sequential pulses.

6. Drive apparatus according to claim 5 wherein the circuitry (6, 7) includes an analog to digital converter (6) configured to sample the signals over a period greater than the periodicity of the sequential pulses.

7. Drive apparatus according to claim 5 or 6 wherein the circuitry (6, 7) includes processing circuitry (7) configured to integrate digital samples of the signals over a period greater than the periodicity of the sequential pulses.

8. Drive apparatus according to claim 5, 6 or 7 including means to adjust the phase of the period relative to the phase of the pulses.

9. Drive apparatus according to any one of claims 5 to 8 wherein the period is a predetermined multiple of the periodicity of said pulses.

10. Drive apparatus according to claim 9 including a counter (14) to count a predetermined number of the pulses to define said period.

# FIG.1

2:ECTRO-OPTIC PROBE

1:EOS OSCILLOSCOPE MAIN BODY

# FIG.2

(a) OUTPUT SIGNAL FROM TRIGGER CIRCUIT

e1  e2  e3  e4  e5  e6  e7  e8

(b) FAST RAMP WAVEFORM

(c) SLOW RAMP WAVEFORM

(d) TIMING SIGNAL FOR SAMPLING OPTICAL PULSE

$f_1$  $f_2$  $f_3$  $f_4$  $f_5$  $f_6$  $f_7$  $f_8$

(e) A/D CONVERSION

$\alpha 1$  $\alpha 2$  $\alpha 3$

EP 0 921 402 A2

# FIG.3

2:ECTRO-OPTIC PROBE

1:EOS OSCILLOSCOPE MAIN BODY

PROCESSING CIRCUIT 6

A/D CONVERTER

INTEGRATION CIRCUIT 7

15

OPTICAL PULSE GENERATION CIRCUIT 5

4b

COUNTER

COMPARATOR 13

14

FAST RAMP GENERATION CIRCUIT 11

SLOW RAMP GENERATION CIRCUIT 12

TRIGGER CIRCUIT 3

# FIG.4

(a) SLOW RAMP WAVEFORM

(b) OUTPUT SIGNAL OF COMPARATOR

$f_1$  $f_2$  $f_3$  $f_4$  $f_5$  $f_6$  $f_7$  $f_8$  . . .

(c) A/D CONVERSION

$\beta 1$  $\beta 2$  $\beta 3$

# FIG.5

2 :ECTRO-OPTIC PROBE

1 :EOS OSCILLOSCOPE MAIN BODY

6

A/D CONVERTER

7

PROCESSING CIRCUIT

5

OPTICAL PULSE GENERATION CIRCUIT

4

TIMING GENERATION CIRCUIT

3

TRIGGER CIRCUIT

# FIG.6

TIMING SIGNAL

4

43

COMPARATOR

41

FAST RAMP
GENERATION
CIRCUIT

42

SLOW RAMP
GENERATION
CIRCUIT

TRIGGER SIGNAL

# FIG.7

(a) SIGNAL FROM
TRIGGER CIRCUIT

(b) FAST RAMP WAVEFORM

(c) SLOW RAMP WAVEFORM

(d) TIMING SIGNAL

(e) A/D CONVERSION

EP 0 921 402 A2